Europäisches Patentamt

European Patent Office

Office européen des brevets

(19)

(11) Numéro de publication: **0 044 368**

**A1**

(12) # DEMANDE DE BREVET EUROPEEN

(21) Numéro de dépôt: **80400978.5**

(22) Date de dépôt: **30.06.80**

(51) Int. Cl.³: **G 01 R 29/12**
**G 01 R 19/14**

(43) Date de publication de la demande:
**27.01.82 Bulletin 82/4**

(84) Etats contractants désignés:
**CH DE GB LI SE**

(71) Demandeur: **Mettler, Jules Eugene Jean**
**38 Avenue St Guinfort**
**F-77230 Dammartin en Goelle(FR)**

(72) Inventeur: **Mettler, Jules Eugene Jean**
**38 Avenue St Guinfort**
**F-77230 Dammartin en Goelle(FR)**

(54) **Dispositif qui permet de contrôler les charges électriques statiques des disques phonographiques.**

(57) Le dispositif concerne la détection des charges statiques des disques phonographiques.
Dispositif comprenant:
1) Amplificateur à très haute impédance (T1 - T4),
2) Amplificateur des signaux négatifs alimentant LED 1,
3) Amplificateur des signaux positifs alimentant LED 2.
Application: Utilisation conjointe aux accessoires anti-statiques des disques phonographiques.

Figure . 1

EP 0 044 368 A1

a)    Dispositif qui permet de contrôler les charges électriques statiques des disques phonographiques.

b)    La présente invention concerne les instruments du type détecteur permettant de déceler les signaux électriques.

c)    Dans les dispositifs connus dans ce genre, nous trouvons des systèmes très sophistiqués basés sur des montages électroniques complexes et variés, faisant appels à des composants électroniques aussi différents les uns des autres.

d)    L'inconvenient de tels systèmes, réside dans le cût que représente la fabrication des instr₪ments réalisés dont l'utilisation ne peut être que par conséquent réservée aux professionnels. Grâce à un système électronique très simplifié, le dispositif de la présente invention permet de réaliser un instrument de détection et de contrôle de charges électriques statiques pour un coût de fabrication peu onéreux.

e)    Description du système ( se référer figure I ) une antenne est connectée sur la porte du transistor à effet de champ (T 1). A l'état de repos, le courant de fuite du transistor T 1 permet d'alimenter la base du transistor T 2 qui devient conducteur et sature le transistor T 3 qui provoque l'alimentation du LED 1 ( diode électroluminescente).

A noter que le condensateur C 1 qui découple R 1 filtre les signaux parasites.

Lorsqu'une charge apparait sur la porte de T 1, celui-ci se bloque ne délivrant aucune tension sur la base de T 2 qui prend la position de repos,ainsi que T 3, qui de ce fait, ne conduit plus et n'alimente plus LED 1.

A ce moment là, T 4 devient conducteur en faisant passer le courant dand LED 2.

f)    Le dispositif, objet de la présente invention peut être utilisé dans tous les cas de détection de charges électriques statiques permettant de déceler celles-ci sur n'importe quels objets ou matières ayant la propriété de se charger.

Ce dispositif peut être utilisé en laboratoire, dans le domaine médicale et pharmaceutique, dans l'industrie pour les matières plastiques, les bandes magnétiques, dans l'imprimerie pour les films photographiques et pour toutes utilisations domestiques.

Une des applications particulièrement intéressante est le contrôle de détection des charges statiques sur les disques phonographiques, ce système permettant de visualiser celles-ci pour les rendre évidente(LED ).

R E V E N D I C A T I O N S

1) Dispositif qui permet de contrôler les charges électriques statiques des disques phonographiques.

2) Dispositif selon revendication 1, caractérisé par le fait qu'il comporte directement une antenne sur la porte du transistor à effet de champ, complèté d'un montage électronique simple ( système Darlington ).

3) Dispositif selon revendication 1, caractérisé par le fait qu'une charge statique quelqu'elle soit peut être détectée par le montage caractérisé par la revendication 2.

Figure . 1

# 0044368

| | DOCUMENTS CONSIDERES COMME PERTINENTS | | CLASSEMENT DE LA DEMANDE (Int. Cl.³) |
|---|---|---|---|
| Catégorie | Citation du document avec indication, en cas de besoin, des parties pertinentes | Revendica-tion concernée | |
| X | FUNKSCHAU, Vol. 45, No. 14, 1973 C. ROCKROHR "Elektronisches Elektro-skop" * page 531 * | 1-3 | G 01 R 29/12 G 01 R 19/14 |
| A | US - A - 4 208 629 (V.R. FRIEBEL et al.) * colonne 4, lignes 18 à 56; fig. 3 * | 1 | |
| A | DE - A1 - 2 823 542 (W.F. ROBSON et al.) * revendications 1, 10; fig. 4 * | | **DOMAINES TECHNIQUES RECHERCHES (Int. Cl.³)** |
| A | US - A - 3 600 678 (J.C. GARRETT et al.) * abrégé; fig. 4 * | | G 01 R 19/14 G 01 R 29/12 G 01 R 29/14 G 01 R 29/24 |

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interference
D: document cité dans la demande
L: document cité pour d'autres raisons
&: membre de la même famille. document correspondant

| X | Le présent rapport de recherche a été établi pour toutes les revendications |
|---|---|

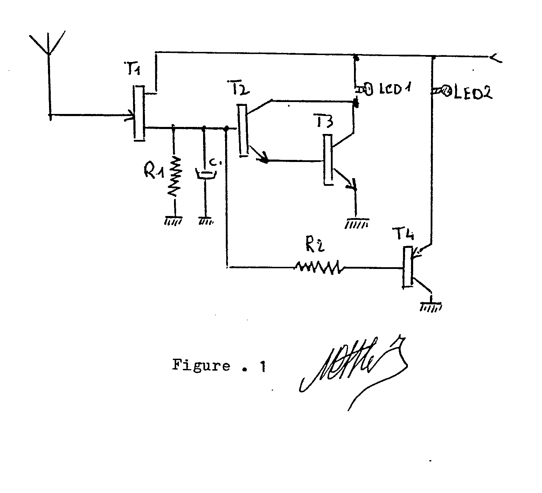

| Lieu de la recherche | Date d'achèvement de la recherche | Examinateur |
|---|---|---|
| Berlin | 17-02-1981 | LEMMERICH |

OEB Form 1503.1   06.78